# NEW EUROPEAN PATENT SPECIFICATION

(11) **EP 2 028 764 B2**
(45) Date of publication and mention of the opposition decision: **29.04.2020**
(45) Mention of the grant of the patent: 16.02.2011
(21) Application number: 08162759.8
(22) Date of filing: 21.08.2008
(51) Int. Cl.: H03J 1/00

(54) **Method and circuit for saving power of remote control according to user position**
Verfahren und Schaltung zum Sparen von Strom bei einer Fernbedienung in Abhängigkeit von der Benutzerposition
Procédé et circuit pour économiser l'énergie pour la télécommande en fonction de la position de l'utilisateur

(30) Priority: 24.08.2007 TR 200705887
(43) Date of publication of application: 25.02.2009
(73) Proprietor: Vestel Elektronik Sanayi ve Ticaret A.S., 45030 Manisa (TR)
(72) Inventor: Gökkaya, Utku, 45030, MANISA (TR)
(74) Representative: Cayli, Hülya

(56) References cited:
- EP-A1- 0 186 684
- EP-A1- 0 438 770
- DE-A1- 3 817 621
- JP-A- 2006 295 635
- US-A- 3 594 796
- US-A- 4 811 421
- US-A- 5 627 565

## Description

### Technical Field

The present invention relates to a method and system for consuming the power of remote controls used particularly in user electronic systems in an efficient manner according to the user's position and for ensuring the correct receiving of the user-sent signals from the remote control by the receiver.

### Prior Art

Systems involving remote controls are being used in the user electronics market for years, having provided the users of remote controls with the opportunity of making more use of such systems by means of conducting the device control in an easier manner. Most of the remote controls used nowadays make use of infrared transmitters, wherein the infrared receivers of an electronic device to be controlled receive the relevant signals transmitted by the remote control, enabling such device to fulfill the commands of the user; if the power of infrared light emitting diodes (LED) are increased in a remote control using infrared transmitters, it becomes possible to receive such infrared rays from relatively longer distances. The output power of many remote control used nowadays is previously set up to a fixed distance, and they cannot build communication with an electronic device located out of the range of such previously determined distance. Additionally, when the predetermined communication distance is assigned to be as a high value, the power consumption on the control increases regardless the user's position, causing to unwanted power consumption and to battery power loss.

A known solution for the problem concerning the fixed power consumption according to predetermined distance in remote controls is disclosed in the patent application JP2006295635A2, in which a sensor provided on a television system determines the distance of the remote control to the television set, and the output power of the remote control is altered according to this distance determined.

In the patent document with patent number US5627565, a space coordinates detecting device is disclosed. The said device comprises a light emitting section having a light source and also comprises a detecting section which senses light emitted from the light source. The said space coordinate detecting device permits detection of relative rotational angle and distance between a light emitting section and a detecting section. However; the said document differs from the present invention because it provides a method for optimizing the power consumed by the remote control in relation to the position of the remote control with respect to the electronic devices it controls.

Although it is possible to adjust the remote controlling power in response to distance within the prior art, it is assumed in the distance measurements that the remote control is operated at the same alignment with the television/entertainment system and the cases are ignored in which the user makes use of the remote control at various angles. As required by the structure of infrared receivers, an infrared receiver fails in efficiently receiving any signal, unless it is transmitted from a perpendicular direction with respect to the position of such infrared receiver; for instance, an infrared remote control fails to communicate with the receiver at the farthest distance in which they can communicate, if the signals establishing such a communication is not transmitted to the receiver at a normal, i.e. perpendicular direction; for example, while a remote control builds communication with a receiver on a television system at a maximum 10 meter perpendicular distance, it fails to communicate with the same at this same distance, when its location is changed and is relocated for example to the right part of such television.

The remote control according to the prior art does not take into account the distance and angular position with respect to controlled devices and consume a fixed power at their outputs.

### Brief Description of Invention

The present invention provides saving of power consumed by the remote control in response to the user's position and the transmittance of signals in a correct manner in an electronic system controlled by a remote control. The present invention may be used in any kind of electronics system that can be controlled by means of a remote control using battery. Thanks to the present invention which adjusts the output power of the remote control according to the position in which the user is present, it becomes possible to use relatively less power at closer distances and to deliver the signals transmitted by the remote control to the target at farther distances.

### Objective of Invention

The objective of the present invention is to determine the distance and angular position of a remote control to the electronic device for optimizing the power consumed by the remote control and to determine the power to be consumed by the remote control in relation to electronic devices controlled by means of remote controls.

A further objective of the present invention is to provide a feedback system for having the receiver correctly interpret the commands transmitted by the remote control, to reduce any failures between the remote control and the system receiving the signals of the remote control, and to provide power saving.

### Description of Figures

In this description, references will be made to annexed figures outlined as following.
Figure 1 is a block diagram illustrating the position of a user and remote control with respect to a television set on which the present invention is implemented.
Figure 2 is a block diagram illustrating the procedure in which the user's location is determined according to the present invention.
Figure 3 is the block diagram of an electronic circuit exemplified for implementing power adjustment on the remote control based on the distance and relative position of the user to the electronic device being controlled.
Figure 4 is a block diagram illustrating the operation algorithm of the present invention.

### Description of Invention

The basic function of the present invention is to optimize the signal transmission power of the remote control by detecting the distance and position of the remote control and of the user to the electronic device controlled remotely.

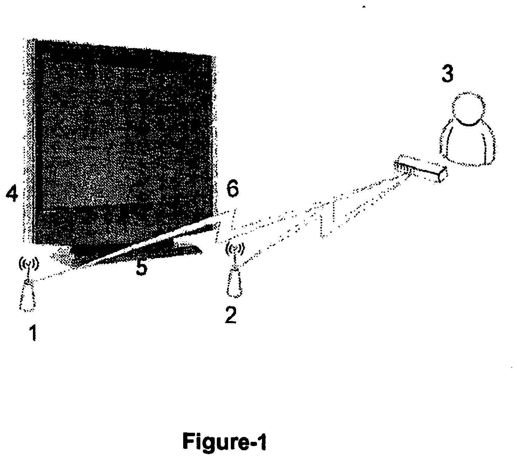

A system of the present invention is illustrated in Figure 1, in which the distance and position of the user is detected with respect to a remotely-controlled device, the present invention assuming the position of a remote control to be the same to the position of the user.

According to an exemplary system, 2 radio transmitters and at least one infrared receiver are provided on a television set controlled remotely, whereas an infrared transmitter, a radio frequency receiver, a comparison circuit for detecting the user's position, and a power adjusting circuit for adjusting the power of the infrared transmitter are provided on the remote control, such components serving to determine the distance and angular position of the user to the television set to be controlled.

The power of radio frequency signals -of which the periods are adjustable- decreases directly proportional to the distance. The distance and position of a receiver to two radio transmitters on a television set can be determined by making use of two factors; the first factor involves the determination of the receiver's distance to the transmitter by comparing the power of received signals to previously stored signal powers, whereas the second factor makes use of broadcasts made by at least two radio transmitters of which their broadcasting frequency are previously known, such that the relative position is determined according to these broadcasting transmitters.

In order to make clear the operating principle of the present invention the block diagram in Figure 1 is provided, this block diagram presenting a television set and a user located at the right of said television set.

In Figure 1, two radio signal transmitters (1, 2) are provided at both sides of the television set. According to the present invention's operating principle, these transmitters do transmit radio signals with different frequencies, the phase differences of received radio frequencies are analyzed at the receiver section on the remote control (3), the power of radio signals received from the radio signal transmitters (1, 2) are compared, and the output power of the infrared transmitter on the remote control is adjusted.

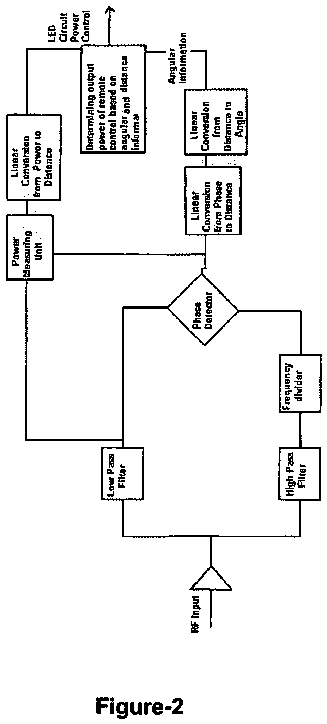

The radio signal transmitters (1, 2) in Figure 1 operate at frequencies f and 2f respectively; it must be kept in mind that the value f is a value present within the operating characteristics of the transmitters. In order to make clear the present invention, the infrared receivers can be positioned at locations indicated as 4, 5, and 6 in Figure 1; according to an exemplary system, only the location 5 is provided with an infrared receiver. The signals sent from the transmitters (1, 2) are received from the control section (3) illustrated in Figure 1. The manner how the remote control section makes distance and angular determination by evaluating the signals received from the radio transmitters (1, 2) is described in detail in the block diagram of Figure 2.

The signals sent from the radio signal transmitters (1, 2) at frequencies f and 2f, as depicted in Figure 1, are received from the RF (radio frequency) input representing the internal structure of the remote control section as illustrated in Figure 2, and the signals entering this input are applied to a low pass filter and high pass filter. The frequency of the low pass filter is previously setup to pass the signals received from transmitter (1) at frequency f, whereas the high pass filter is previously arranged to pass the signals received from the transmitter (2) at frequency 2f. In Figure 2, the frequency of signals with 2f frequency passed through the high pass filter is reduced back to f by means of a frequency divider; the purpose of obtaining signal at two f frequencies is to find the phase difference between the signals. If the phase difference between the signals sent from two radio transmitters with known frequencies and the horizontal distance between these two transmitters are known, the distance and angular position of a signal-receiving device relative to the signal-sending source can be mathematically calculated.

As illustrated in Figure 2, the phase difference between the signals output from the frequency divider and the signals output from the low pass filter can be found by means of a phase detector. The phase detector finding the phase difference between two signal transmitters delivers the phase difference information to a system for linear conversion from phase to distance. A system conducting linear conversion from phase to distance yields the angular information between the radio transmitters (1, 2) in Figure 1.

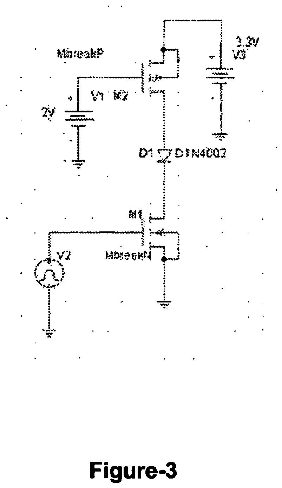

In addition to the angular information, the distance of one of the signals to the remote control must be known as well. As illustrated in Figure 2, the outputs of the low pass filter and the phase detector are connected to a power measuring unit; the reason here is to measure the power of the signal with frequency f at the output of the low pass filter by taking into account the phase difference. After the power of signals received from the transmitter broadcasting at frequency f is measured at the power measuring system together with the phase information, the linear conversion unit from power to distance illustrated in Figure 2 is used for calculating the distance equivalence of signal powers detected so as to yield the distance information. The angular position of the remote control to the receiver of the television system is found, thanks to the linear conversion unit from distance to angle, whereas the distance of the remote control with respect to the television system is determined by means of the linear conversion unit from power to distance. The angular position and distance information of the remote control to the television system is evaluated by the unit determining the remote control power based on the angular and distance information; this unit may be a microprocessor within the remote control; this unit generates an output voltage according to the angular position and distance it detects. The output voltage generated is changed by means of the LED-power adjustment circuit indicated in Figure 3. The power is controlled of the infrared LED at the control driver circuit and the LED power adjustment circuit in Figure 3; when the distance is close and the remote control is perpendicular to the television set, the output power of the remote control is minimized, whereas when the distance is far and the remote control is angularly located with respect to the television set, the output power of the remote control is adjusted to be as maximum; the behavior as to which power adjustment is to be made against which position shall be previously determined by the manufacturer.

Thanks to measuring the signal power of any of the transmitters (1, 2 in Figure 1) sending signals at frequencies f and 2f respectively, and to finding the phase difference between two signals, the distance and angular position of the remote control with respect to the receiver (5) on the television set can be found. Although the user may be present at the right of the television as illustrated in Figure 1, not the direction (either right or left), but the distance and angular position of the user with respect to the receiver (5) is to be known while power adjustment is made; thus, the same power adjustment is to be made even if the user is present at the relative left symmetry of said receiver (5) provided on the television set.

After the position of the user is determined with respect to the television system, the unit for determining the output power of control from angular and distance information illustrated in Figure 2 generates a variable voltage at the "MbreakP" input of the LED power adjustment circuit in Figure 3. According to the operation principle of the LED power adjustment circuit illustrated in Figure 3, it serves to generate resistance proportional to the voltage value applied to the gate input of the transistor M2 and opens. The voltage supply (V2) illustrated in Figure 3 activates when the remote control is to send a signal and applies voltage to the gate of the transistor M1 so as to switch this transistor to conduction, so that this conducting transistor M1 allows current be passed through the LED (D1N4002 for this example) and infrared light be emitted from this LED. The voltage V2 in Figure 3 is activated by means of a microprocessor in the remote control, when it is desired to send a signal, and the transistor generates resistance according to the value of voltage received from the unit for determining the remote control output power based on angular and distance information so that the current to be passed through the LED is altered. In the circuit illustrated according to the present invention, it is assumed that the user's position is calculated and 2 volts are applied by means of the unit for determining the remote control output power based on angular and distance information to the gate of the transistor M2 for adjusting the current passed via the LED and adjusting the output power of the remote control in Figure 3.

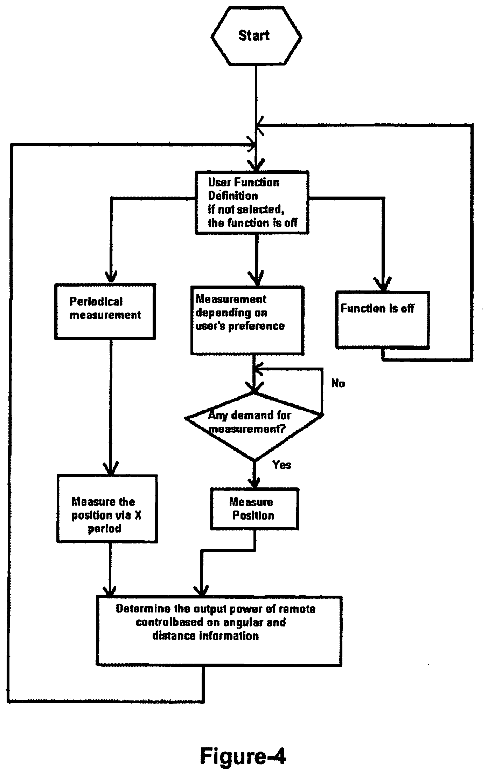

Although the system included in the remote control is to consume power for adjusting the output power of the remote control thanks to the present invention, the saving in power to be obtained following the adjustment made on the control's output power substantially increases the life of batteries used in such remote controllers. Either a key on the remote control may be previously assigned for optimizing the output power of the remote control, or the power adjustment according to the user's position can be conducted periodically. A block diagram is illustrated in Figure 4, indicating the feasibility of power adjustment at more than one condition. If the user activates the power adjustment according to the present invention, the power adjustment is carried out periodically at a previously set period according to the user's wish, or in place of such an automatic periodical adjustment, the user may depress a previously-assigned key on the remote control so as to conduct the remote control's output power adjustment.

According to the present invention, more than one infrared receiver is used as in Figure 1, illustrating an exemplary system, and in a further preferred system of the present invention, infrared receivers are located at points (4, 6). The reason of locating more than one infrared receiver at the lateral sides of a remotely-controlled electronic device it to solve the infrared receiver's problem related to receiving signals from lateral (i.e. right/left) angles; for such a solution in which the present invention is used with this method, a small modification must be carried on the system design, it must be determined as to which of the infrared receivers (4, 6) is relatively nearer to the user, and the power adjustment must be made according to the result of this determination.

The present invention can be used in all electronic devices controlled by means of remote controls operating by means of battery power, and can provide both the power saving feature and a correct signal transmission thanks to the optimized signal output power referred to hereinabove.

## Claims

1. A method for saving power of a remote control according to user position in an electronic system controllable by means of a remote control, wherein said electronic system comprises more than one infrared receiver (4, 6) at its lateral sides, comprising the steps in which
• said remote control transmits infrared signals with variable signal power to said electronic system with an infrared signal transmitter (3),
• said electronic system sends radio signals to said remote control, these radio signals indicating the position or location of said electronic system,
• said remote control detects the radio signals indicating the position of said electronic system so as to generate position information with respect to said electronic device,
**characterised in that,**
• said remote control determines which of the infrared receivers (4, 6) is relatively nearer based on the generated position information,
• said remote control adjusts the signal power of the infrared signals with variable signal power according to the position information it produces with respect to the determined nearer infrared receiver (4 or 6).

2. A method according to Claim 1, **characterized in that** the radio signals indicating the position of said electronic system are transmitted to said remote control by means of more than one transmitter (1, 2).

3. A method according to Claim 1, **characterized in that** said position information contain angular and distance information of said remote control with respect to said electronic device.

4. A system for saving power of a remote control according to user position in an electronic system controllable by means of a remote control, **characterized in that**
• said remote control comprises an infrared signal transmitter (3),
• said electronic system comprises more than one infrared receiver (4, 6) at its lateral sides for receiving infrared signals from the infrared signal transmitter,
• said electronic system comprises at least two radio signal transmitters (1, 2) indicating the position thereof,
• said remote control comprises a unit capable of determining angular and distance position with respect to said electronic device, once said remote control detects radio signals transmitted from said at least two radio signal transmitters, and determines which of the infrared receivers (4, 6) is relatively nearer,
• the output power of said infrared signal transmitter is adjusted according to said angle- and distance-dependant position with respect to the nearer infrared receiver (4 or 6) determined by said remote control.

## Patentansprüche

1. Verfahren zum Sparen des Stroms einer Fernsteuerung entsprechend einer Benutzerposition in einem elektronischen System, das mittels einer Fernsteuerung gesteuert werden kann, wobei das elektronische System mehr als einem Infrarotempfänger (4, 6) an seinen lateralen Seiten aufweist, umfassend die folgenden Schritte, bei denen
• die Fernsteuerung die Infrarotsignale mit variabler Signalleistung an das elektronische System mit einem Infrarot-Signalsender (3)überträgt,
• das elektronische System die Funksignale an die Fernsteuerung schickt, wobei diese Funksignale die Position oder örtliche Lage des elektronischen Systems angeben,
• die Fernsteuerung die Funksignale, die die Position des elektronischen Systems angeben, erfasst, um Positionsinformation im Hinblick auf das elektronische Gerät zu generieren, **dadurch gekennzeichnet, dass**
• die Fernsteuerung erfasst, welcher der Infrarotempfänger (4, 6) auf der Basis der generierten Positionsinformation relativ näher ist,
• die Fernsteuerung die Signalleistung der Infrarotsignale mit variabler Signalleistung entsprechend der Positionsinformation, die sie im Hinblick auf den bestimmten näheren Infrarotempfänger (4 oder 6) generiert, einstellt.

2. Verfahren nach Anspruch 1, **dadurch gekennzeichnet, dass** die Funksignale, die die Position des elektronischen Systems angeben, mittels mehr als einem Sender (1, 2) an die Fernsteuerung übertragen werden.

3. Verfahren nach Anspruch 1, **dadurch gekennzeichnet, dass** die Positionsinformation Winkel- und Abstandsinformation der Fernsteuerung im Hinblick auf das elektronische Gerät enthält.

4. System zum Sparen des Stroms einer Fernsteuerung entsprechend einer Benutzerposition in einem elektronischen System, das mittels einer Fernsteuerung gesteuert werden kann, **dadurch gekennzeichnet, dass**
• die Fernsteuerung einen Infrarot-Signalsender (3) umfasst,
• das elektronische System mehr als einem Infrarotempfänger (4, 6) an seinen lateralen Seiten umfasst, um die Infrarotsignale von dem Infrarot-Signalsender zu empfangen,
• das elektronische System mindestens zwei Funksignalsender (1, 2) umfasst, die seine Position angeben,
• die Fernsteuerung eine Einheit umfasst, die in der Lage ist, die Winkel- und Abstandsposition im Hinblick auf das elektronische Gerät zu bestimmen, sobald die Fernsteuerung die von den mindestens zwei Funksignalsendern übertragenen Funksignale erfasst und, erfasst welcher der Infrarotempfänger (4, 6) relativ näher ist,
• die Ausgangsleistung des Infrarot-Signalsenders im Hinblick auf den näheren Infrarotempfänger (4 oder 6) entsprechend der winkel- und abstandsabhängigen Position eingestellt wird, die durch die Fernsteuerung bestimmt wurde.

## Revendications

1. Procédé pour économiser l'énergie d'une télécommande selon la position d'un utilisateur dans un système électronique contrôlable au moyen d'une télécommande, dans lequel ledit système électronique comprend plus d'un récepteur infrarouge (4, 6) sur ses côtés latéraux, comprenant les étapes dans lesquelles
- ladite télécommande transmet des signaux infrarouges avec une puissance de signal variable audit système électronique avec un émetteur de signal infrarouge (3),
- ledit système électronique envoie des signaux radio à ladite télécommande, ces signaux radio indiquant la position ou l'emplacement dudit système électronique,
- ladite télécommande détecte les signaux radio indiquant la position dudit système électronique de sorte à générer des informations de position par rapport audit dispositif électronique,
**caractérisé en ce que**
- ladite télécommande détermine lequel des récepteurs infrarouges (4, 6) est relativement plus proche sur la base des informations de position générées,
- ladite télécommande ajuste la puissance de signal des signaux infrarouges à puissance de signal variable selon les informations de position qu'elle produit par rapport au récepteur infrarouge le plus proche déterminé (4 ou 6).

2. Procédé selon la revendication 1, **caractérisé en ce que** les signaux radio indiquant la position dudit système électronique sont transmis à ladite télécommande au moyen de plusieurs émetteurs (1, 2).

3. Procédé selon la revendication 1, **caractérisé en ce que** lesdites informations de position contiennent les informations d'angle et de distance de ladite télécommande par rapport audit dispositif électronique.

4. Système pour économiser l'énergie d'une télécommande selon une position d'utilisateur dans un système électronique contrôlable au moyen d'une télécommande, **caractérisé en ce que**
- ladite télécommande comprend un émetteur de signaux infrarouge (3),
- ledit système électronique comprend plus d'un récepteur infrarouge (4, 6) sur ses côtés latéraux destiné à recevoir des signaux infrarouges de l'émetteur de signaux infrarouges,
- ledit système électronique comprend au moins deux émetteurs de signaux radio (1, 2) indiquant sa position,
- ladite télécommande comprend une unité capable de déterminer la position angulaire et la distance par rapport audit dispositif électronique, une fois que ladite télécommande détecte les signaux radio transmis par lesdits au moins deux émetteurs de signaux radio, et détermine lequel des récepteurs infrarouges (4, 6) est relativement plus proche,
- la puissance de sortie dudit émetteur de signaux infrarouge est ajustée selon ladite position dépendant de l'angle et de la distance par rapport au récepteur infrarouge le plus proche (4 ou 6) déterminée par ladite télécommande.
